# EUROPÄISCHE PATENTANMELDUNG

(11) **EP 2 398 037 A1**
(43) Veröffentlichungstag der Anmeldung: **21.12.2011**
(21) Anmeldenummer: 11170466.4
(22) Anmeldetag: 19.06.2011
(51) Int. Cl.: H01J 37/32, H05H 1/48

(54) **Anordnung und Verfahren zur dropletarmen Beschichtung von Substraten mit einem Vakuumlichtbogenverdampfer**

(30) Priorität: 18.06.2010 DE 102010024244
(71) Anmelder: Grimm, Herr Werner, 01326 Dresden (DE)
(72) Erfinder: Grimm, Herr Werner, 01326 Dresden (DE)
(74) Vertreter: Pätzelt, Peter

(57) **Zusammenfassung**

Die Erfindung betrifft eine Anordnung und ein Verfahren zur dropletarmen Beschichtung von Substraten (4) mit einem Vakuumlichtbogenverdampfer (7), der seitlich neben den zu beschichtende Substraten (4) angeordnet ist. Der von der Oberfläche des Targets (8) ausgehende Plasmastrahl ist parallel zur Oberfläche der zu beschichtenden Substrate (4) gerichtet. Eine magnetische Ablenkeinrichtung bewirkt eine der Richtung des Plasmastrahls (9) in Richtung der Substrate (4). Die Magnete (11, 12) der Ablenkeinrichtung sind während der Beschichtung örtlich verschiebbar und/oder, wenn das Magnetfeld mit Elektromagneten erzeugt wird, ist eine Vorrichtung zur Veränderung des Spulenstromes vorhanden. Verfahrensgemäß kann die Stromzuführung zum Vakuumlichtbogenverdampfer (7) derart gesteuert werden, dass eine gepulste Vakuumbogenentladung bewirkt wird.

## Beschreibung

### Anwendungsgebiet der Erfindung

Die Erfindung betrifft eine Anordnung und ein Verfahren zur dropletarmen Beschichtung von Substraten mit einem Vakuumlichtbogenverdampfer, insbesondere zur Beschichtung von großen Bauteilen oder einer Vielzahl von Bauteilen in einer Vakuumkammer nach dem Oberbegriff des Anspruchs 1 bzw. des Anspruchs 5.

### Hintergrund der Erfindung

Die plasmagestütze Beschichtung mit einem Vakuumlichtbogenverdampfer, auch als Vakuumbogen- oder Lichtbogenverdampfer bezeichnet, hat gegenüber anderen Verfahren wesentliche Vorteile. Das hat insbesondere zu einer breiten industriellen Anwendung der Vakuumlichtbogenverdampfer für die Beschichtung von Werkzeugen und Maschinenbauteilen mit harten oder verschleißfesten Schichten geführt. Ein Vorteil ist z.B., dass mit dem Vakuumlichtbogenverdampfer abgeschiedene Schichten auf Werkzeugen und Bauteilen deutlich haftfester abgeschieden werden können als mit anderen PVD-Verfahren (PVD - physical vapor deposition; physikalische Gasphasenabscheidung). Die weit verbreiteten Verschleißschutzschichten TiN, TiCN, TiAIN und CrN werden heute nahezu ausnahmslos mit Vakuumlichtbogenverdampfern erzeugt. Auch harte diamantähnliche amorphe Kohlenstoffschichten werden mit Vakuumlichtbogenverdampfern hergestellt.

Weitere Vorteile sind die einfache Verfahrensführung, die hohe Verdampfungsleistung und die so genannte kalte Katode. Der Verdampfer weist kein Schmelzbad auf und er kann innerhalb der Beschichtungskammer beliebig angeordnet werden. Die Verdampfung von oben nach unten ist ebenso möglich wie die Verdampfung in horizontale Richtung.

Verfahrenstypisch wird das zu verdampfende Material im Vakuumlichtbogenverdampfer als Target auf katodisches Potential gelegt. Die Anode ist eine spezielle Elektrode oder es wird einfach die Wand der Beschichtungskammer mit der Anode der Stromversorgung verbunden.

Zur Zündung einer Entladung wird die Anode meist kurzzeitig mit der Katode verbunden, so dass auf der Katode ein kleiner Lichtbogen entsteht, der schließlich die Vakuumbogenentladung zündet. Danach brennt die Vakuumbogenentladung selbstständig zwischen dem katodischem Target und einer Anode, zum Beispiel der Kammerwand. Auf der anodischen Seite richtet sich die Entladung auf die gesamte Anodenfläche. Auf der Oberfläche der Katode fokussiert sich die Entladung auf einen einzigen Punkt, den Katodenfleck. Der Katodenfleck wandert mit hoher Geschwindigkeit über die Oberfläche des Targets und ändert stochastisch seine Richtung und Geschwindigkeit. Innerhalb des Katodenflecks, der eine hohe Energiedichte aufweist, erodiert das Material explosionsartig aus der festen Phase. Der Materialdampf, der aus dem Katodenfleck austritt, ist hochgradig ionisiert.

Nachteilig ist, dass es innerhalb des Katodenflecks zu Aufschmelzungen kommt und kleine Schmelztröpfchen, so genannte Droplets, aus dem Katodenfleck geschleudert werden. Die Droplets gelangen auch bis zur Substratoberfläche und führen dort zu Störungen im Schichtaufbau, schlimmstenfalls zu einer Apfelsinenschalenstruktur, also zu einer sehr rauen Schichtoberfläche. In der Praxis kann die Verfahrensführung deshalb nur in Arbeitsbereichen geführt werden, in denen die Dropletemission klein ist. Die Entladung muss bei möglichst kleinen Strömen betrieben werden. Typisch sind 80 bis 120 A bei 15 bis 22 V Spannungsabfall.

Die US 2011/0068004 A1 gibt eine Einrichtung zur Erzeugung eines Plasmas und ein Verfahren zu Anwendung an, mit denen im Plasma enthaltene Droplets effektiv entfernt werden können und eine verbesserte Filmbildung in einem Plasma mit hoher Reinheit erzielt wird. Von einer Plasmaerzeugungseinrichtung ausgehend wird der Plasmastrahl erst durch ein gerades Rohr in ein daran rechtwinklig angesetztes zweites Rohr und danach in einem angesetzten schrägen Rohr weiter über ein zum zweiten Rohr paralleles Rohr in die Beschichtungskammer geleitet. Durch die Richtungsänderungen werden die Droplets mit großer Wahrscheinlichkeit in den Rohrabschnitten kondensiert und abgelagert. Am Austritt in die Beschichtungskammer steht ein weitgehend dropletfreier Plasmastrom zur Beschichtung zur Verfügung. Nachteilig ist, dass nur eine sehr kleine Substratfläche am Ausgang des Rohres beschichtet werden kann.

Die EP 0 666 335 B1 gibt ein Verfahren zum Betreiben eines Vakuumlichtbogenverdampfers mit einer gepulsten Vakuumbogenentladung an, bei der die Dropletemission ebenfalls wesentlich reduziert werden kann. Der Vakuumlichtbogenverdampfer besteht aus einem katodischen Target, einer Anode, einem Zündmechanismus und einer Gleichstromquelle, wobei zwischen dem katodischen Target und der Anode mittels des Zündmechanismus bei ausreichender Spannungsdifferenz und Stromversorgung ein Vakuumlichtbogen gezündet wird, der im Wesentlichen im Plasma des dabei verdampften Materials selbständig weiter brennt. Verfahrensgemäß wird einem Grundstrom, der zum stabilen Betrieb des Vakuumlichtbogenverdampfers erforderlich ist, ein pulsierender Strom überlagert, dessen Frequenz mindestens 1 Hz und die Amplitude mindestens 10 A beträgt.

### Darlegung der Erfindung

Ausgehend vom bekannten Stand der Technik liegt der Erfindung die Aufgabe zugrunde, eine Anordnung und ein Verfahren zur dropletarmen Beschichtung von Substraten mit einem Vakuumlichtbogenverdampfer anzugeben, bei denen mit vergleichbar geringen technischen Aufwendungen eine gleichmäßige und dropletarme Beschichtung von ausgedehnten, großen Bauteilen oder die gleichzeitige Beschichtung von vielen Bauteilen in einer Vakuumkammer möglich ist.

Die erfindungsgemäße Lösung nutzt die Eigenfokussierung des Plasmastrahls der Vakuumbogenentladung und beeinflusst den Plasmastrahl derart, dass dieser während der Beschichtung gezielt über die Oberfläche der Substrate bewegt wird. Für eine allseitige Beschichtung können die Substrate bewegt oder gedreht werden.

Die Aufgabe zur Anordnung für eine dropletarme Beschichtung von Substraten mit einem Vakuumlichtbogenverdampfer nach dem Oberbegriff des Anspruchs 1 wird dadurch gelöst, dass die Magnete einer Ablenkeinrichtung während der Beschichtung örtlich verschiebbar sind und/oder, wenn das Magnetfeld mit Elektromagneten erzeugt wird, eine Vorrichtung zur Veränderung des Spulenstromes vorhanden ist.

Die Ablenkeinrichtung ist in der Nähe des katodischen Targets angeordnet, so dass der rechtwinklig von der Targetoberfläche ausgehende Plasmastrahl in Richtung der Substrate ablenkt wird.

Zur Verschiebung der Magnete der Ablenkeinrichtung kann ein Antrieb vorhanden sein, der die Magnete während der Beschichtung in Richtung des Targets hin- und herbewegt.

An der Ablenkeinrichtung kann auch mindestens eine zusätzliche Blende vorhanden sein, mit der der Plasmastrahl vor den Substraten eingegrenzt wird, derart dass nur der zentrale Teil des Plasmastrahles auf die Oberfläche der Substrate auf.

Weiterhin kann eine Einrichtung zur Pulsung des Vakuumlichtbogenverdampfers vorhanden sein.

Die Aufgabe zum Verfahren für eine dropletarme Beschichtung von Substraten mit einem Vakuumlichtbogenverdampfer nach dem Oberbegriff des Anspruchs 5 wird dadurch gelöst, dass die örtliche Lage der Magnete der Ablenkeinrichtung und/oder beim Vorhandensein von Elektromagneten zur Erzeugung eines Magnetfeldes deren Spulenstrom während der Beschichtung derart verändert werden, dass der Plasmastrahl während eines Beschichtungszyklus alle Bereiche der Oberfläche der zu beschichtenden Substraten überstreicht.

Vorteilhaft ist die Stromzuführung zum Vakuumlichtbogenverdampfer derart, dass eine gepulste Vakuumbogenentladung bewirkt wird. Damit wird die Gefahr der Abscheidung von Droplets auf den Substraten nahezu vollständig beseitigt. Der mit einem gepulsten Vakuumlichtbogenverdampfer erzeugte Plasmastrahl ist ein besonders kräftiger, fokussierter Plasmastrahl, der vom Katodenfleck auf dem Target ausgeht. Bei einem kleinen Arbeitsdruck < 10⁻⁴ mbar beträgt der Öffnungswinkel des Plasmastrahls weniger als 15 Grad. Dieser fokussierte Plasmastrahl wird in erfindungsgemäßer Weise mit einfachen technischen Mitteln abgelenkt, ohne dass seine Intensität wesentlich abnimmt.

In vorteilhafter Weise kreuzen die Feldlinien der Magnete der Ablenkeinrichtung den Plasmastrahl senkrecht. Zur Erzeugung eines Magnetfeldes können sowohl Permanentmagnete als auch Elektromagnete zum Einsatz kommen.

Die Ablenkung des Strahls in Richtung der Substrate kann auch zusätzlich noch durch Blenden oder Ableitbleche unterstützt werden.

Die Ablenkeinrichtung wird derart gesteuert, dass während eines Beschichtungszyklus der Plasmastrahl die Bereiche eines großen Substrates oder einer Vielzahl von Substraten auf einer Substratträgereinrichtung mindestens einmal überstreicht, ähnlich einem Pinsel. Bei Erfordernis kann in einem Beschichtungszyklus der Plasmastrahl auch mehrmals und/oder differenziert über die Oberfläche der Substrate bewegt werden.

Ein besonderer Vorteil der erfindungsgemäßen Lösung besteht darin, dass mit nur einem einzigen Vakuumlichtbogenverdampfer mit der erfindungsgemäßen Ablenkeinrichtung große Substrate oder eine Vielzahl von Substraten gleichzeitig beschichtet werden können. Die Abscheidung einer homogenen Schicht über das gesamte Substrat bzw. für alle Substrate wird allein durch die Steuerung der Ablenkeinrichtung und gegebenenfalls durch eine laterale Bewegung oder Drehung der Substrate um eine Drehachse erreicht.

Bei besonders hohen Anforderungen an die gleichmäßige Beschichtung kann die Ablenkeinrichtung abhängig von mehreren in-situ Mess-Sonden für die Schichtdicke gesteuert werden.

Der wesentliche Vorteil der erfindungsgemäßen Lösung besteht darin, dass die verfahrensbedingt auftretenden Droplets aus dem Targetmaterial die Substrate nicht auf direktem Wege erreichen können. Die abgeschiedenen Schichten sind außerordentlich dropletarm.

Falls der Anteil der Droplets noch weiter gesenkt werden soll, kann eine zusätzliche Blende vor den Substraten angebracht werden, die nur über ein Loch verfügt, das letztlich nur den zentralen Teil des Endes des Plasmastrahls vor den Substraten freigibt. Zu beachten ist jedoch, dass die Beschichtungsrate im Vergleich zu einer Anordnung ohne Blende sinkt. Die Blende kann für den Normalbetrieb des Vakuumlichtbogenverdampfers auch jederzeit wieder entfernt werden.

Je nach technologischer Anforderung können mit der erfindungsgemäßen Lösung in der gleichen Beschichtungsanordnung sowohl dropletarme Schichten als auch (fast) dropletfreie, glatte Schichten hergestellt werden.

Im Gegensatz zu bekannten Lösungen wird in der erfindungsgemäßen Lösung auf abgewinkelte Rohre oder ähnliche Einrichtungen zur Führung des Plasmas verzichtet. Auch Magnetspulen zur unmittelbaren Fokussierung des Plasmastrahles in Führungseinrichtungen sind nicht erforderlich.

### Beschreibung einer bevorzugten Ausführungsform

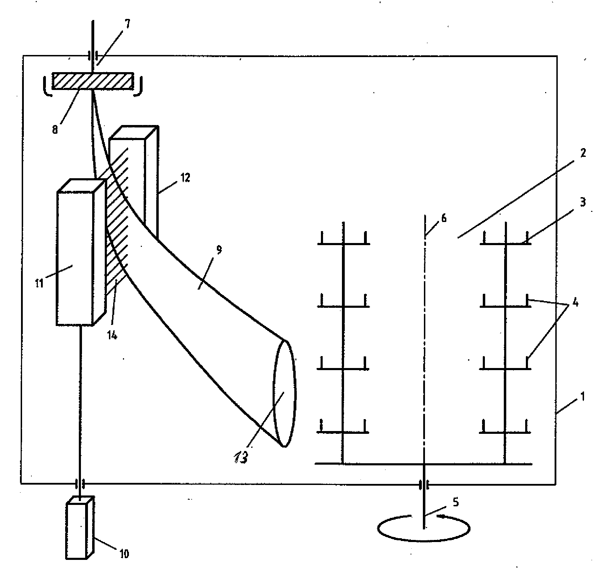

Die Erfindung wird nachstehend an einem Ausführungsbeispiel näher erläutert. Zugehörig zeigt die Figur eine schematische Ansicht einer erfindungsgemäßen Anordnung mit einem Vakuumlichtbogenverdampfer, der gegenüber den zu beschichtenden Substraten angeordnet ist.

Verfahrensgemäß sollen mit der Anordnung Bauteile und Schneidwerkzeuge mit hartem Kohlenstoff beschichtet werden. Auf die Vakuumerzeugung, die gepulste Vakuumbogenentladung, Beimischung von anderen Schichtmaterialien, Zumischung von Prozessgasen und die Vorbehandlung der Substratoberflächen wird hier nicht eingegangen. Derartige Ausführungen zur Schichtabscheidung und zur gepulsten Vakuumbogenentladung sind nach dem Stand der Technik bekannt und sind beispielhaft in "Grimm, Plasma Process. Polym. 2009, 6, S.433-S.437, 2009 WILEY-VCH Verlag, Weinheim" dargelegt.

Die zugehörige Zeichnung zeigt in einer Vakuumkammer 1 einen Drehkorb 2 mit Substrathaltern 3. Die zu beschichtenden Substrate 4 werden von den Substrathaltern 3 gehalten und mittels eines Drehantriebes 5 ständig um die Drehachse 6 bewegt.

Innerhalb der Vakuumkammer 1 wird ein Arbeitsdruck von 4 x 10⁻⁴ mbar aufrecht erhalten. Der Vakuumlichtbogenverdampfer 7 ist seitlich zu den Substraten 4 angeordnet. Auf dem katodischen Target 8 brennt eine gepulste Vakuumbogenentladung. Die gepulste Vakuumbogenentladung erzeugt einen Plasmastrahl 9, der senkrecht vom Target 8 des Vakuumlichtbogenverdampfers 7 abgeht und bei 4 x 10⁻⁴ mbar einen typischen Öffnungswinkel von ca. 15 Grad aufweist.

Der Plasmastrahl 9 führt Elektronen und erodierte Ionen aus dem Material des Targets 8 mit sich. Daneben werden Droplets aus dem heißen Katodenfleck (Fußpunkt) des Plasmastrahls 9 herausgeschleudert.

Unter dem Vakuumlichtbogenverdampfer 7 sind im Ausführungsbeispiel zwei Magnete 11 und 12 in Form von Permanentmagneten angeordnet. Die Magnete 11 und 12 erzeugen ein Magnetfeld 14, das senkrecht zur Richtung des Plasmastrahls 9 gerichtet ist. Das Magnetfeld 14 bewirkt eine Ablenkung des Plasmastrahls 9 in Richtung der Substrate 4. Das Ende 13 des Plasmastrahls 9 erreicht die Substrate 4. Die Ionen des Targetmaterials, die mit dem Plasmastrahl 9 zu den Substraten transportiert werden, kondensieren auf den Substratoberflächen zu einer Schicht. Da das Ende 13 des Plasmastrahls 9 auf den unteren Teil der Substrate 4 gerichtet ist, kann vorerst nur hier eine Schicht wachsen.

Verfahrensgemäß werden die Magnete 11 und 12 durch den Antrieb 10 allmählich nach oben verschoben. Die Verschiebung der Magnete 11 und 12 und folglich die Verschiebung des Magnetfeldes 14 nach oben bewirkt, dass sich das Ende 13 des Plasmastrahls 9 ebenfalls nach oben verschiebt und auch die oberen Substrate 4 beschichtet werden.

Im einfachsten Fall reicht es aus, das Ende 13 des Plasmastrahls 9 ähnlich einem Pinsel einmal von unten nach oben zu verschieben, um alle Substrate 4 gleichmäßig zu beschichten. Noch gleichmäßigere Beschichtungen sind möglich, wenn das Ende 13 des Plasmastrahls 9 mehrfach von unten nach oben und von oben nach unten bewegt wird. Mitunter kann es von Vorteil sein, die Oberflächen der Substrate 4 vielfach wiederholt und sehr rasch mit dem Ende 13 des Plasmastrahls 9 zu überstreichen oder die Oberflächen sehr schnell mit dem Ende 13 des Plasmastrahls 9 zu rastern.

Statt der beiden Permanentmagnete können als Magnete 11 und 12 auch Elektromagnete eingesetzt werden. Dabei kann beim Einsatz von zwei oder mehreren Elektromagneten auch auf den mechanischen Antrieb 10 verzichtet werden. Die Ablenkung des Plasmastrahls 9 kann dann allein über den Spulenstrom der Elektromagnete gesteuert werden.

Die Ablenkeinrichtung kann in spezifischen Fällen auch aus mindestens einem Ableitblech bestehen, dessen Lage oder dessen elektrische Potential während der Beschichtung verändert wird, derart dass die Position des Endes 13 des Plasmastrahls 9 auf den Substraten 4 verändert wird.

Es ist auch möglich, eine zusätzliche Blende vorzusehen, die vor den Substraten nur einen zentralen Teil des Endes 13 des Plasmastrahles (9) zu den Substraten (4) durch lässt.

### Liste der verwendeten Bezugszeichen

- 1: Vakuumkammer
- 2: Drehkorb
- 3: Substrathalter
- 4: Substrate
- 5: Drehantrieb
- 6: Drehachse
- 7: Vakuumlichtbogenverdampfer
- 8: Target
- 9: Plasmastrahl
- 10: Antrieb
- 11: Magnet
- 12: Magnet
- 13: Ende des Plasmastrahls
- 14: Magnetfeld

## Patentansprüche

1. Anordnung zur dropletarmen Beschichtung von Substraten (4) mit einem Vakuumlichtbogenverdampfer (7), der seitlich neben den zu beschichtende Substraten (4) angeordnet ist, wobei der von der Oberfläche des Targets (8) ausgehende Plasmastrahl im Wesentlichen parallel zur Oberfläche der zu beschichtenden Substrate (4) gerichtet ist, und einer magnetischen Ablenkeinrichtung zur Veränderung der Richtung des Plasmastrahls (9) in Richtung der Substrate (4) mit mindestens zwei Magneten (11, 12), deren Magnetfeldlinien den Plasmastrahl (9) kreuzen, **dadurch gekennzeichnet, dass** die Magnete (11, 12) der Ablenkeinrichtung während der Beschichtung örtlich verschiebbar sind und/oder, wenn das Magnetfeld mit Elektromagneten erzeugt wird, eine Vorrichtung zur Veränderung des Spulenstromes vorhanden ist.

2. Anordnung nach Anspruch 1, **dadurch gekennzeichnet, dass** die Ablenkeinrichtung einen Antrieb (10) aufweist, der die Magnete (11, 12) während der Beschichtung in Richtung der Targets (8) hin- und herbewegen kann.

3. Anordnung nach Anspruch 1, **dadurch gekennzeichnet, dass** an der Ablenkeinrichtung mindestens eine zusätzliche Blende vorhanden ist, die vor den Substraten (4) nur den zentralen Teil des Plasmastrahles (9) zu den Substraten (4) durchlässt.

4. Anordnung nach Anspruch 1, **dadurch gekennzeichnet, dass** eine Einrichtung zur Pulsung des Vakuumlichtbogenverdampfers (7) vorhanden ist.

5. Verfahren zur dropletarmen Beschichtung von Substraten (4) mit einem Vakuumlichtbogenverdampfer (7), der seitlich neben den zu beschichtende Substraten (4) angeordnet ist, wobei der von der Oberfläche des Targets (8) ausgehende Plasmastrahl (9) im Wesentlichen parallel zur Oberfläche der zu beschichtenden Substrate (4) gerichtet ist, und einer magnetischen Ablenkeinrichtung zur Veränderung der Richtung des Plasmastrahls (9) in Richtung der Substrate (4) mit mindestens zwei Magneten (11, 12), deren Magnetfeldlinien den Plasmastrahl (9) kreuzen, **dadurch gekennzeichnet, dass** die örtliche Lage der Magnete (11, 12) und/oder beim Vorhandensein von Elektromagneten zur Erzeugung eines Magnetfeldes (14) deren Spulenstrom während der Beschichtung verändert werden.

6. Verfahren nach Anspruch 5, **dadurch gekennzeichnet, dass** die Stromzuführung zum Vakuumlichtbogenverdampfer (7) derart erfolgt, dass eine gepulste Vakuumbogenentladung bewirkt wird.

## Geänderte Patentansprüche

### Geänderte Patentansprüche gemäss Regel 137(2) EPÜ.

**1.** Anordnung zur dropletarmen Beschichtung von großen Substraten (4) oder Substratanordnungen mit einem Vakuumlichtbogenverdampfer (7), der seitlich neben den zu beschichtende Substraten (4) angeordnet ist, wobei der von der Oberfläche des Targets (8) ausgehende Plasmastrahl im Wesentlichen parallel zur Oberfläche der zu beschichtenden Substrate (4) gerichtet ist, und einer magnetischen Ablenkeinrichtung zur Veränderung der Richtung des Plasmastrahls (9) in Richtung der Substrate (4) mit mindestens zwei Magneten (11, 12), deren Magnetfeldlinien den Plasmastrahl (9) kreuzen, **dadurch gekennzeichnet, dass**
- die Magnete (11, 12) der Ablenkeinrichtung während der Beschichtung örtlich verschiebbar sind und/oder,
- wenn das Magnetfeld mit Elektromagneten erzeugt wird, eine Vorrichtung zur Veränderung des Spulenstromes vorhanden ist und
- dass die Substrate (4) während der Beschichtung bewegbar sind.

**2.** Anordnung nach Anspruch 1, **dadurch gekennzeichnet, dass** die Ablenkeinrichtung einen Antrieb (10) aufweist, der die Magnete (11, 12) während der Beschichtung in Richtung der Targets (8) hin- und herbewegen kann.

**3.** Anordnung nach Anspruch 1, **dadurch gekennzeichnet, dass** an der Ablenkeinrichtung mindestens eine zusätzliche Blende vorhanden ist, die vor den Substraten (4) nur den zentralen Teil des Plasmastrahles (9) zu den Substraten (4) durchlässt.

**4.** Anordnung nach Anspruch 1, **dadurch gekennzeichnet, dass** eine Einrichtung zur Pulsung des Vakuumlichtbogenverdampfers (7) vorhanden ist.

**5.** Verfahren zur dropletarmen Beschichtung von großen Substraten (4) oder Substratanordnungen mit einem Vakuumlichtbogenverdampfer (7), der seitlich neben den zu beschichtende Substraten (4) angeordnet ist, wobei der von der Oberfläche des Targets (8) ausgehende Plasmastrahl (9) im Wesentlichen parallel zur Oberfläche der zu beschichtenden Substrate (4) gerichtet ist, und einer magnetischen Ablenkeinrichtung zur Veränderung der Richtung des Plasmastrahls (9) in Richtung der Substrate (4) mit mindestens zwei Magneten (11, 12), deren Magnetfeldlinien den Plasmastrahl (9) kreuzen, **dadurch gekennzeichnet, dass** die örtliche Lage der Magnete (11, 12) und/oder beim Vorhandensein von Elektromagneten zur Erzeugung eines Magnetfeldes (14) deren Spulenstrom während der Beschichtung verändert werden.

**6.** Verfahren nach Anspruch 5, **dadurch gekennzeichnet, dass** die Stromzuführung zum Vakuumlichtbogenverdampfer (7) derart erfolgt, dass eine gepulste Vakuumbogenentladung bewirkt wird.

**7.** Verfahren zur dropletarmen Beschichtung von großen Substraten (4) mit einer Anordnung zur dropletarmen Beschichtung von großen Substraten (4) nach einem der Anspruch 1 bis 4, **dadurch gekennzeichnet, dass** die Substrate (4) während der Beschichtung dem Vakuumlichtbogenverdampfer (7) bewegt werden.
